# EUROPEAN PATENT APPLICATION

(11) **EP 4 646 048 A1**
(43) Date of publication of application: **05.11.2025**
(21) Application number: 25173028.9
(22) Date of filing: 28.04.2025
(51) Int. Cl.: H05K 7/20

(54) **LOCATION-AWARE CLIMATE CONTROL**

(30) Priority: 29.04.2024 US 202463639814 P; 22.04.2025 US 202519186335
(71) Applicant: Vertiv Corporation, Westerville, OH 43082 (US)
(72) Inventor: Takacs, Balint, Westerville, 43082 (US); Barbato, Pierpaolo, Westerville, 43082 (US)
(74) Representative: Cousens, Nico

(57) **Abstract**

A climate control system may include climate sensors distributed within an environment containing a plurality of loads as well as control units distributed within the environment. The system may include a controller communicatively coupled with the climate sensors and the climate control units. The controller may receive localized climate data from the climate sensors. The controller may determine, for each of the climate control units, load-specific impact data associated with at least one incremental change of one or more operational settings on the loads based on the localized climate data. The controller may identify a localized climate anomaly based on the localized climate data. The controller may provide, in response to the localized climate anomaly, a targeted climate adjustment of at least one of the one or more operational settings of a subset of the climate control units based on the load-specific impact data.

## Description

### RELATED APPLICATION

The present application claims the benefit under 35 U.S.C. § 119(e) of U.S. Provisional Application Serial Number 63/639,814, filed April 29, 2024, entitled LOCATION-AWARE CLIMATE CONTROL.

### TECHNICAL FIELD

The present disclosure relates generally to climate control of a data center, and more particularly, to efficient climate control of a data center using location-aware climate control modules.

### BACKGROUND

Climate control is a critical and challenging aspect of data center operations. A data center may include multiple server units distributed throughout a room, where each server unit may generate varying amounts of heat during operation based on factors such as operational load and local climate conditions. A data center may typically include a climate control system to regulate temperatures of the various server units during operation and respond to any variations over time. For example, a typical climate control system may include multiple climate control units distributed across the room to regulate the climate (e.g., temperature, humidity, or the like) within the data center. Further, it may be desirable for a climate control system to maintain a target temperature that balances server performance with the cost of operating the climate control system.

In many applications, such climate control units are linked or grouped together (e.g., in a teamwork mode) such that they operate together, which may prevent conflicting operation of different units in ways that may include simultaneous humidification/dehumidification, simultaneous heating/cooling, or the like. However, such a configuration may struggle to mitigate hotspots associated with a localized temperature increase of one or more servers and/or the surrounding environments. In particular, such a configuration may simultaneously utilize all of the climate control units in response to a hotspot, which may fix the hotspot but result in undercooling of other portions of the data center. This undercooling can result in substantial energy usage and associated cost.

There is therefore a need to develop systems and methods to address the above deficiencies.

### SUMMARY

In embodiments, the techniques described herein relate to a climate control system, including a plurality of climate sensors distributed within an environment containing a plurality of loads; a plurality of climate control units distributed within the environment; and a controller communicatively coupled with the plurality of climate sensors and the plurality of climate control units, where the controller includes one or more processors configured to execute program instructions stored on a memory device, where the program instructions are configured to cause the one or more processors to receive localized climate data from the plurality of climate sensors; determine, for each of the plurality of climate control units, load-specific impact data associated with at least one incremental change of one or more operational settings on the plurality of loads based on the localized climate data; identify a localized climate anomaly based on the localized climate data; and provide, in response to the localized climate anomaly, a targeted climate adjustment of at least one of the one or more operational settings of a subset of the plurality of climate control units based on the load-specific impact data.

In embodiments, the techniques described herein relate to a climate control system, where the one or more operational settings include at least one of a temperature setting, a humidity setting, or a fan speed.

In embodiments, the techniques described herein relate to a climate control system, where determining, for each of the plurality of climate control units, the load-specific impact data associated with at least one incremental change of one or more operational settings on the plurality of loads based on the localized climate data includes implementing, for each of the plurality of climate control units individually, the at least one incremental change of one or more operational settings on the plurality of loads based on the localized climate data; and determining the load-specific impact data associated with the at least one incremental change of one or more operational settings on the plurality of loads.

In embodiments, the techniques described herein relate to a climate control system, where the localized climate anomaly includes a hotspot.

In embodiments, the techniques described herein relate to a climate control system, where providing the targeted climate adjustment of the at least one of the one or more operational settings of the subset of the plurality of climate control units based on the load-specific impact data includes ranking the plurality of climate control units by relative impact on the localized climate anomaly based on the load-specific impact data; and adjusting the at least one of the one or more operational settings for a highest-ranked one of the plurality of climate control units.

In embodiments, the techniques described herein relate to a climate control system, where providing the targeted climate adjustment of the at least one of the one or more operational settings of the subset of the plurality of climate control units based on the load-specific impact data includes ranking the plurality of climate control units by relative impact on the localized climate anomaly based on the load-specific impact data; and adjusting the at least one of the one or more operational settings for one or more additional climate control units of one of the plurality of climate control units based on the rank.

In embodiments, the techniques described herein relate to a climate control system, where the load-specific impact data includes positional information associated with the plurality of loads within the environment.

In embodiments, the techniques described herein relate to a climate control method, including receiving localized climate data from a plurality of climate sensors distributed within an environment containing a plurality of loads; determining, for each of a plurality of climate control units within the environment, load-specific impact data associated with at least one incremental change of one or more operational settings on the plurality of loads based on the localized climate data; identifying a localized climate anomaly based on the localized climate data; and providing, in response to the localized climate anomaly, a targeted climate adjustment of at least one of the one or more operational settings of a subset of the plurality of climate control units based on the load-specific impact data.

In embodiments, the techniques described herein relate to a climate control method, where the one or more operational settings include at least one of a temperature setting, a humidity setting, or a fan speed.

In embodiments, the techniques described herein relate to a climate control method, where determining, for each of the plurality of climate control units, the load-specific impact data associated with at least one incremental change of one or more operational settings on the plurality of loads based on the localized climate data includes implementing for each of the plurality of climate control units individually, the at least one incremental change of one or more operational settings on the plurality of loads based on the localized climate data; and determining the load-specific impact data associated with the at least one incremental change of one or more operational settings on the plurality of loads.

In embodiments, the techniques described herein relate to a climate control method, where the localized climate anomaly includes a hotspot.

In embodiments, the techniques described herein relate to a climate control method, where providing the targeted climate adjustment of the at least one of the one or more operational settings of the subset of the plurality of climate control units based on the load-specific impact data includes ranking the plurality of climate control units by relative impact on the localized climate anomaly based on the load-specific impact data; and adjusting the at least one of the one or more operational settings for a highest-ranked one of the plurality of climate control units.

In embodiments, the techniques described herein relate to a climate control method, where providing the targeted climate adjustment of the at least one of the one or more operational settings of the subset of the plurality of climate control units based on the load-specific impact data further includes ranking the plurality of climate control units by relative impact on the localized climate anomaly based on the load-specific impact data; and adjusting the at least one of the one or more operational settings for one or more additional climate control units of one of the plurality of climate control units based on the rank.

In embodiments, the techniques described herein relate to a climate control method, where the load-specific impact data includes positional information associated with the plurality of loads within the environment.

In embodiments, the techniques described herein relate to a climate control system, including a controller configured to be communicatively coupled with a plurality of climate sensors distributed within an environment containing a plurality of loads, and further configured to be communicatively coupled with a plurality of climate control units, where the controller includes one or more processors configured to execute program instructions stored on a memory device, where the program instructions are configured to cause the one or more processors to receive localized climate data from the plurality of climate sensors; determine, for each of the plurality of climate control units, load-specific impact data associated with at least one incremental change of one or more operational settings on the plurality of loads based on the localized climate data; identify a localized climate anomaly based on the localized climate data; and provide, in response to the localized climate anomaly, a targeted climate adjustment of at least one of the one or more operational settings of a subset of the plurality of climate control units based on the load-specific impact data.

In embodiments, the techniques described herein relate to a climate control system, where the one or more operational settings include at least one of a temperature setting, a humidity setting, or a fan speed.

In embodiments, the techniques described herein relate to a climate control system, where determining, for each of the plurality of climate control units, the load-specific impact data associated with at least one incremental change of one or more operational settings on the plurality of loads based on the localized climate data includes implementing, for each of the plurality of climate control units individually, the at least one incremental change of one or more operational settings on the plurality of loads based on the localized climate data; and determining the load-specific impact data associated with the at least one incremental change of one or more operational settings on the plurality of loads.

In embodiments, the techniques described herein relate to a climate control system, where providing the targeted climate adjustment of the at least one of the one or more operational settings of the subset of the plurality of climate control units based on the load-specific impact data includes ranking the plurality of climate control units by relative impact on the localized climate anomaly based on the load-specific impact data; and adjusting the at least one of the one or more operational settings for a highest-ranked one of the plurality of climate control units.

In embodiments, the techniques described herein relate to a climate control system, where providing the targeted climate adjustment of the at least one of the one or more operational settings of the subset of the plurality of climate control units based on the load-specific impact data includes ranking the plurality of climate control units by relative impact on the localized climate anomaly based on the load-specific impact data; and adjusting the at least one of the one or more operational settings for one or more additional climate control units of one of the plurality of climate control units based on the rank.

In embodiments, the techniques described herein relate to a climate control system, where the load-specific impact data includes positional information associated with the plurality of loads within the environment.

### BRIEF DESCRIPTION OF THE DRAWINGS

The numerous advantages of the disclosure may be better understood by those skilled in the art by reference to the accompanying figures.
FIG. 1 is a block diagram of a climate control system, in accordance with one or more embodiments of the present disclosure.
FIG. 2 is a flow diagram illustrating steps performed in a method for location-aware climate control, in accordance with one or more embodiments of the present disclosure.
FIG. 3 is a simplified schematic of an environment with four climate control units distributed around a central bank of loads, where the environment is in a steady state operation, in accordance with one or more embodiments of the present disclosure.
FIGS. 4A-4D are simplified schematics illustrating the generation of load-specific impact data from different climate control units, in accordance with one or more embodiments of the present disclosure.
FIG. 5A is a simplified schematic of an environment with one of the climate control units in a first operational setting, in accordance with one or more embodiments of the present disclosure.
FIG. 5B is a simplified schematic of an environment with one of the climate control units in a second operational setting, in accordance with one or more embodiments of the present disclosure.
FIG. 5C is a simplified schematic of an environment with one of the climate control units in a third operational setting, in accordance with one or more embodiments of the present disclosure.
FIG. 6 is a simplified schematic depicting a configuration of the environment in which a particular operational setting of a climate control unit provides different temperature profiles on different loads, in accordance with one or more embodiments of the present disclosure.
FIG. 7 is a flow diagram depicting the determination of load-specific impacts associated with various climate control units, in accordance with one or more embodiments of the present disclosure.
FIG. 8A depicts a distribution of load-specific impact data for a single climate control unit and a single climate sensor per load, in accordance with one or more embodiments of the present disclosure.
FIG. 8B depicts a distribution of load-specific impact data for a single climate control unit and multiple climate sensors, in accordance with one or more embodiments of the present disclosure.
FIG. 8C depicts a distribution of load-specific impact data for multiple climate control units and multiple climate sensors, in accordance with one or more embodiments of the present disclosure.
FIG. 9A is a schematic of the environment in FIG. 3 in which a load exhibits an increased temperature, in accordance with one or more embodiments of the present disclosure.
FIG. 9B is a schematic of the environment in FIG. 9A in which the climate control unit 102d is activated to mitigate the hotspot and reduce the temperature of the load, in accordance with one or more embodiments of the present disclosure.
FIG. 10 is a flow diagram depicting the implementation of a targeted climate adjustment by selected climate control units in response to an identified hotspot, in accordance with one or more embodiments of the present disclosure.

### DETAILED DESCRIPTION

Reference will now be made in detail to the subject matter disclosed, which is illustrated in the accompanying drawings. The present disclosure has been particularly shown and described with respect to certain embodiments and specific features thereof. The embodiments set forth herein are taken to be illustrative rather than limiting. It should be readily apparent to those of ordinary skill in the art that various changes and modifications in form and detail may be made without departing from the scope of the disclosure.

Embodiments of the present disclosure are directed to systems and methods providing location-aware climate control of loads distributed throughout an environment such as, but not limited to, a room. In embodiments, a climate control system includes multiple climate control units distributed around the environment to regulate the climate in the environment as well as climate sensors distributed around the environment to provide location-specific climate information. As used herein, climate regulation may refer to the regulation of any parameter or condition such as, but not limited to, temperature or humidity. In embodiments, the relative impact of each climate control unit on various loads within the environment is determined. In this way, the climate control system may provide a targeted response to an identified localized climate anomaly (e.g., hotspot) by activating one or more climate control units having the greatest impact on the hotspot. For example, the climate control system may first activate a climate control unit known to have the greatest (or at least substantial) impact on the particular location associated with the hotspot, continue to evaluate the impact, and optionally activate one or more additional climate control units if necessary. It is contemplated herein that such a configuration may beneficially provide energy and cost-efficient climate control.

As used herein, activation of a climate control unit is used to describe adjusting an operational setting to provide more intense climate control (e.g., increasing a fan speed, lowering a temperature setpoint, or the like) than provided by a current steady-state condition. For instance, if a climate control unit is operating at 80% for a particular operational setting in a steady-state condition, then it may be activated to operate anywhere between 80-100% to provide a targeted climate response. In another instance, climate control unit may be powered off in a steady-state condition and activated to provide a targeted climate response.

The systems and methods disclosed herein may be suitable for use in numerous applications. In some embodiments, the systems and methods disclosed herein are used to provide climate control of a data center. For example, a data center may include multiple servers (or racks of servers) as loads distributed throughout an environment (e.g., one or more rooms). Accordingly, in some embodiments, a climate control system may include climate control units and climate sensors distributed around the environment to control the climate (e.g., temperature, humidity, or the like) within the data center. It is to be understood that the various examples provided herein related to implementation of a climate control system in the context of a data center are merely illustrative and should not be interpreted as limiting the scope of the present disclosure.

It is contemplated herein that each climate control unit may have a spatially-varying impact on the climate within the data center. As an illustration, a particular climate control unit may have the greatest impact on locations of the data center closest the unit and decreasing impact as a function of distance from the unit. For this reason, a climate control system may include multiple climate control units spatially distributed around the data center. However, it is further contemplated herein that the precise impact of any particular climate control unit on any particular server (e.g., load) may be a complex and dynamic interaction between many parameters such as, but not limited to, the size of the environment, the number and distribution of servers, the number and distribution of climate control units, the heat output of the servers as a function of time, the efficiency and/or responsivity of the climate control units as a function of time, and so on. It may thus be impractical and/or undesirable to simulate the load-specific impact of each climate control unit.

Instead, the systems and methods disclosed herein provide for the dynamic learning of load-specific impacts of each climate control unit through location-specific climate monitoring in response to systematic adjustments to individual climate control units from steady state conditions. This learning process may be implemented in a controlled manner prior to a run-time operational mode and/or may be implemented during a run-time operational mode at identified steady state conditions. In this way, the learning process may be dynamically updated and may respond to changing conditions within the data center. Additionally, the systems and methods disclosed herein may be implemented in any environment (e.g., data center) having any design.

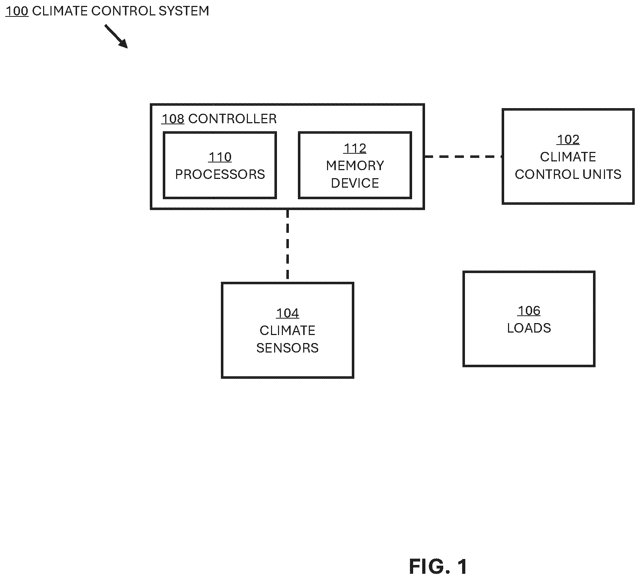

Referring now to FIGS. 1-10, systems and methods providing location-aware climate control are described in greater detail, in accordance with one or more embodiments of the present disclosure.

FIG. 1 is a block diagram of a climate control system 100, in accordance with one or more embodiments of the present disclosure.

In some embodiments, the climate control system 100 includes climate control units 102 as well climate sensors 104 distributed throughout an environment.

The climate control units 102 may include any component or combination of components suitable for regulating one or more climate parameters such as, but not limited to, temperature or humidity. In some embodiments, any of the climate control units 102 may include a temperature regulation unit such as, but not limited to a cooler, a heater, or a combination thereof. Such a temperature regulation unit may control the temperature using any technique such as, but not limited to, a radiative technique or a forced-air technique (e.g., incorporating one or more fans to control air flow). In some embodiments, any of the climate control units 102 may include a humidity regulation unit such as, but not limited to, a condenser or an evaporator.

In some embodiments, one or more loads 106 are distributed throughout the environment, where a load 106 may include any object that impacts the climate surrounding it. As an example in the context of a data center, the load 106 may include a server that may generate differing amounts of heat during operation based on the operational conditions (e.g., varying computational tasks).

The climate sensors 104 may include any type of sensor suitable for generating data indicative of any climate parameter such as, but not limited to, temperature or humidity. In some embodiments, the climate sensors 104 may include an environmental sensor that may determine climate data in a particular location of the environment, where this climate data may be associated with one or more nearby loads 106. In some embodiments, the climate sensors 104 may be attached to a particular load 106 and may provide dedicated data associated with that load 106.

The environment may include any location suitable for containing one or more loads 106 that may impact the climate within the environment such as, but not limited to, one or more rooms.

In embodiments, the climate control system 100 includes a controller 108. The controller 108 may include one or more processors 110 and/or a memory device 112 (e.g., memory medium). Further, the controller 108 may be communicatively coupled to any components within the climate control system 100 such as, but not limited to, the climate control units 102 and the climate sensors 104. The one or more processors 110 of the controller 108 may thus execute any of the various process steps described throughout the present disclosure either directly or indirectly by generating control signals that direct additional components to perform actions.

The one or more processors 110 may include a processing element known in the art configured to execute algorithms and/or instructions (e.g., program instructions stored in the memory device 112). In this way, the program instructions may be configured to cause the one or more processors 110 to implement various processing steps as described herein. The one or more processors 110 may include any device having one or more processing or logic elements such as, but not limited to, one or more microprocessor devices, one or more application specific integrated circuit (ASIC) devices, one or more field programmable gate arrays (FPGAs), or one or more digital signal processors (DSPs), one or more central processing units (CPUs), or one or more graphical processing units (GPUs).

The memory device 112 may include any storage medium known in the art suitable for storing program instructions executable by the one or more processors 110. For example, the memory device 112 may include a non-transitory memory medium. By way of another example, the memory device 112 may include, but is not limited to, a read-only memory (ROM), a random-access memory (RAM), a magnetic or optical memory device (e.g., disk), a magnetic tape, a solid-state drive, or the like.

The processors 110 and/or the memory device 112 may be distributed between any number of housings and/or between any number of devices. For example, the processors 110 and/or the memory device 112 forming the controller 108 may be provided in a common housing such as, but not limited to, a server. In this configuration, the server incorporating the controller 108 may be located locally (e.g., one of the loads 106 in the environment) or remotely (e.g., in a different room, implemented as a cloud server, or the like). As another example, the processors 110 and/or the memory device 112 may be distributed between components of the climate control system 100 such as, but not limited to, the climate control units 102.

Further, any given task may be implemented by one or more processors 110 within a common device or distributed between different devices of the climate control system 100 using any processing architecture or strategy such as, but not limited to, single-threaded processing, multi-threaded processing, parallel processing, or distributed processing.

In some embodiments, the controller 108 operates as a master controller 108 that may be communicatively coupled with local controllers in or associated with any of the climate control units 102. In this configuration, a particular climate control unit 102 may include a local controller (e.g., localized processors and/or memory) suitable for providing localized control over its operation, where the local controller may be communicatively coupled with the master controller 108. For example, the local controller on any particular climate control unit 102 may include device-specific hardware and/or software (e.g., program instructions) suitable for operation of the particular climate control unit 102. The local controller may further accept commands from the master controller 108, which may be device agnostic. As an illustration, the master controller 108 may direct a local controller on a particular climate control unit 102 to increase a fan speed by a selected increment, where the local controller may implement this task based on device-specific instructions. In this configuration, the master controller 108 may provide high-level instructions to different types of climate control units 102, where the local controllers on the different types of climate control units 102 may implement the high-level instructions using device-specific instructions.

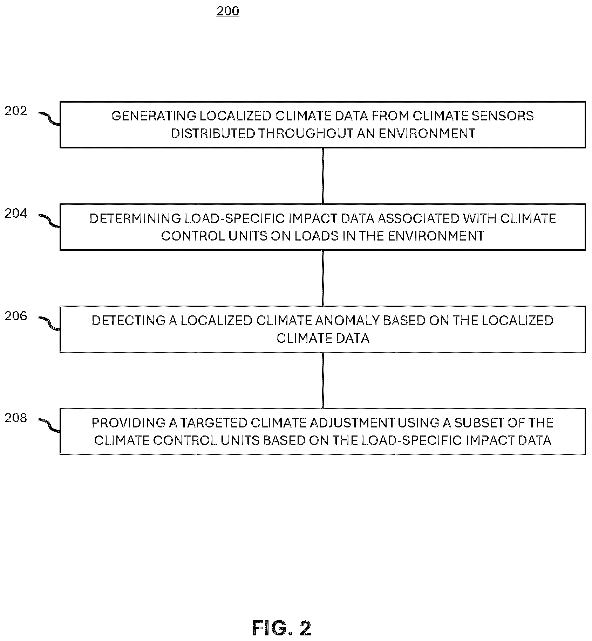

Referring now to FIG. 2, FIG. 2 is a flow diagram illustrating steps performed in a method 200 for location-aware climate control, in accordance with one or more embodiments of the present disclosure. The embodiments and enabling technologies described previously herein in the context of the climate control system 100 should be interpreted to extend to method 200. For example, the controller 108 may directly or indirectly (e.g., via control signals or transmitted instructions) implement any of the various steps of the method 200. It is further noted, however, that the method 200 is not limited to the architecture of the climate control system 100.

In some embodiments, the method 200 includes a step 202 of generating localized climate data from the climate sensors 104 distributed throughout an environment. This localized climate data may then be transmitted to (e.g., received by) the controller 108 for additional actions.

The step 202 may include the generation of any type of localized climate data directly or indirectly related to loads 106 in an environment or of the environment itself. For example, the localized climate data may include data such as, but not limited to, temperature or humidity. In some cases, localized climate data may be associated with a location in the environment that may be influenced by one or more loads 106. In some cases, localized climate data may be associated with a particular load 106.

In some embodiments, the method 200 include a step 204 of determining load-specific impact data associated with the climate control units 102 on loads 106 in the environment. This load-specific impact data may characterize how particular climate control units 102 may influence particular loads 106. In this way, the load-specific impact data may indicate that certain climate control units 102 may have a greater influence on the climate around some loads 106 compared to others.

For example, the step 204 may include determining, for each climate control unit 102 within an environment (or at least some climate control units 102), load-specific impact data associated with at least one incremental change of one or more operational settings on the climate control units 102 based on the localized climate data from the climate sensors 104 distributed throughout an environment. In this way, the step 204 may be a learning step, where the relative impact of incremental variations of operational settings (e.g., a temperature setting, a humidity setting, a fan speed, or any other suitable setting) of each climate control unit 102 on each load 106 is determined.

Put another way, the step 204 may include adjusting an operational setting on a particular climate control unit and monitoring the associated impact using the climate sensors 104. Any operational setting may be varied including, but not limited to, a fan speed, a temperature set point, or a humidity set point. Further, the load-specific impact data may include location data associated with a physical location of each load 106 within the environment generally and/or its proximity to each climate control unit 102. In this way, data generated by the climate sensors 104 may be associated with particular loads 106 and/or particular locations within the environment. In some cases, the step 204 includes generating load-specific impact data associated with different magnitudes of operational settings. As an illustration, the step 204 may include generating load-specific impact data based on changing a temperature setpoint by 1 degree, 5 degrees, 10 degrees, or the like.

This learning step 204 may be performed during run-time (e.g., in response to incremental changes of operational settings driven by a climate control algorithm) and/or in a preliminary step (e.g., a calibration step, a training step, or the like), where the incremental changes of operational conditions are intentionally implemented for the purpose of generating the load-specific impact data.

In some embodiments, the method 200 includes a step 206 of detecting a localized climate anomaly based on the localized climate data. A localized climate anomaly may include any undesired spatial variation of climate data within the environment. As an illustration in the context of a data center, a localized climate anomaly may be a local temperature increase around one or more loads 106 (e.g., a hotspot). However, this is merely an illustration and does not limit the scope of the present disclosure.

The step 206 of detecting a localized climate anomaly may be implemented (or may occur) at any time including, but not limited to run-time operation or a preliminary step.

In some embodiments, the method 200 further includes a step 208 of providing a targeted climate adjustment using a subset of the climate control units 102 based on the load-specific impact data. In this step 208, a localized climate anomaly (e.g., a hotspot) may be mitigated using the particular climate control units 102 that have the greatest impact.

For example, one or more climate control units 102 known to have the greatest impact on the climate around the localized climate anomaly (e.g., based on the load-specific impact data generated in step 204) may be activated to efficiently mitigate the localized climate anomaly. The load-specific impact data may further be used to determine specific operational settings of the one more activated climate control units 102 that are expected to mitigate the climate anomaly. As an illustration, the load-specific impact data generated in step 204 may include data associated with multiple temperature settings (e.g., -1 degree, -5 degrees, -10 degrees, or the like). In this way, the targeted climate adjustment may include an operational setting of one or more climate control units 102 expected to efficiently mitigate the localized climate anomaly.

In contrast to traditional climate control schemes that implement indiscriminate climate control, the step 208 may activate only selected climate control units 102 to efficiently address the localized climate anomaly. In many cases, the step 208 may include activation of one or more climate control units 102 that are physically close to the localized climate anomaly. However, this is not a requirement. Rather, the step 208 may utilize the load-specific impact data generated in step 204 to determine the appropriate climate control units 102 to active as well as the particular operational settings of those climate control units 102. In this way, the method 200 may be responsive to the particular characteristics of the environment.

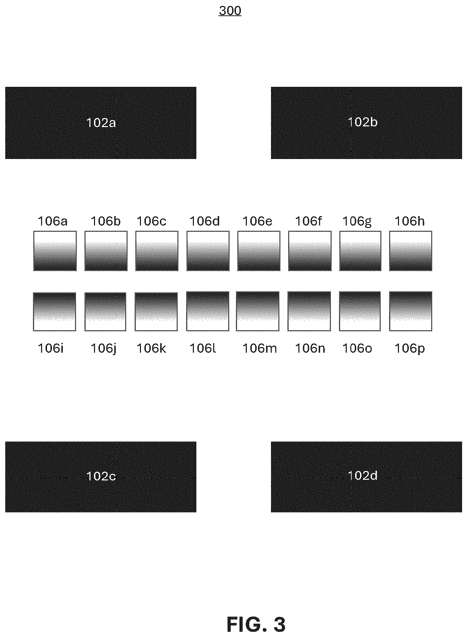

Referring now to FIGS. 3-10, various aspects of the method 200 are described in greater detail, in accordance with one or more embodiments of the present disclosure. FIGS. 3-10 illustrate a non-limiting implementation of a climate control system 100 in a data center, though this is merely illustrative and should not be interpreted as limiting the scope of the present disclosure. Further, the climate sensors 104 are not depicted for clarity, but may be distributed to provide the climate data depicted in the various figures. Further, temperature profiles of the climate control units 102 in FIGS. 3-10 are depicted with gradients, where white represents relatively cooler temperatures and black represents relatively warmer temperatures. However, the gradients depicted in FIGS. 3-10 are merely illustrative and are intended solely to depict the presence of temperature variations rather than a precise representation of any particular temperature profile.

FIG. 3 is a simplified schematic of an environment 300 with four climate control units 102 (labeled as climate control units 102a-102d) distributed around a central bank of loads 106 (e.g., servers or racks of servers), where the environment 300 is in a steady state operation, in accordance with one or more embodiments of the present disclosure. For example, the climate control units 102 may be positioned and be operating in a manner that each of the loads 106 has a stable temperature profile. FIG. 3 further depicts a condition where some spatial variations of temperature are present, even in this steady state condition. In particular, the arrangement of the climate control units 102 around a perimeter of the central bank of loads 106 results in a temperature gradient for each load 106 in which the temperature is relatively cooler on sides facing the climate control units 102 and relatively warmer towards a central area near other loads 106.

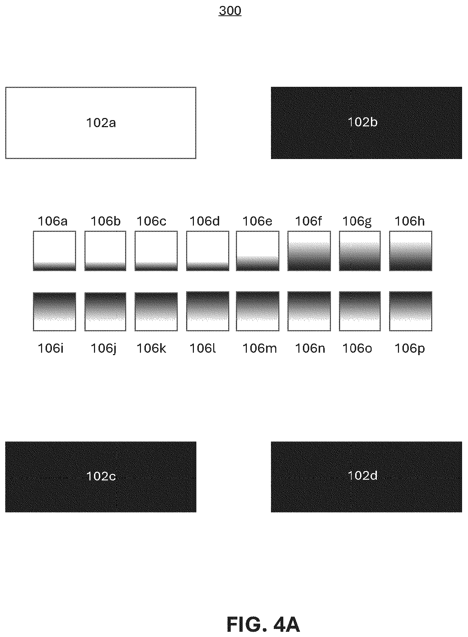

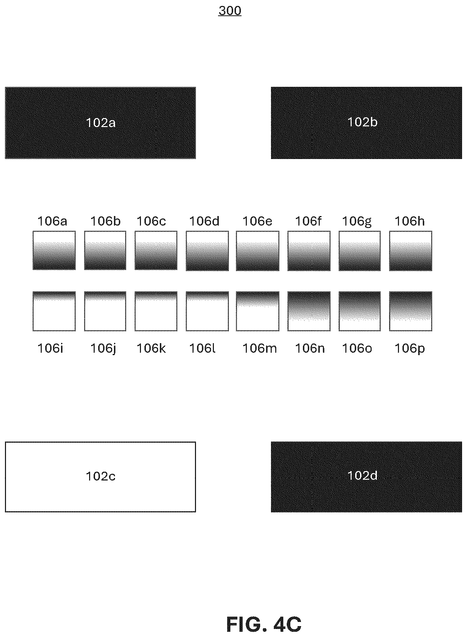

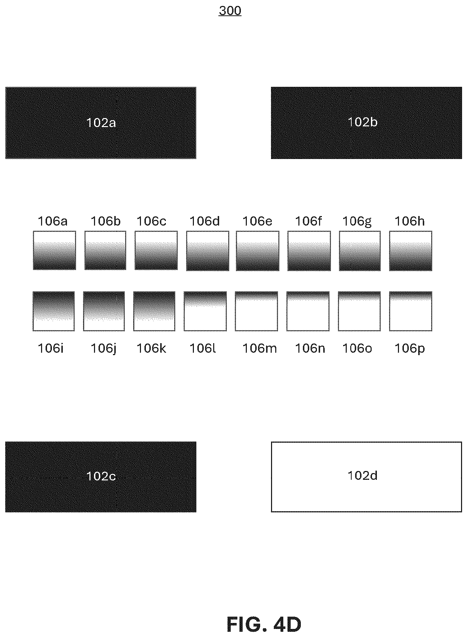

FIGS. 4A-4D are simplified schematics illustrating the generation of load-specific impact data from different climate control units 102 (e.g., associated with step 204 of the method 200), in accordance with one or more embodiments of the present disclosure.

In some embodiments, load-specific impact data is generated by intentionally modifying an operational setting (e.g., a temperature setting, a humidity setting, a fan setting, or the like) of a single climate control unit 102 by a known amount during a steady-state condition and evaluating the impact on each of the loads 106. This process may be repeated for any number of increments of the operational setting and/or any number of different operational settings on a particular climate control unit 102 and further repeated for all of the climate control units 102. In some embodiments, the environment 300 may be allowed to return to a steady-state condition prior to each intentional modification of each operational setting on each climate control unit 102.

FIG. 4A is a simplified schematic of the environment 300 in FIG. 3 depicting a load-specific impact of a first climate control unit 102a in response to a temperature setting decrease (e.g., increased cooling), in accordance with one or more embodiments of the present disclosure. As shown, loads closes to the first climate control unit 102a are more substantively impacted than loads 106 that are further away and/or shielded. In particular, loads 106a-d are significantly cooled; load 106e is impacted, but to a slightly lesser extent; and loads 106f-h are negligibly impacted. Further, loads 106i-p are shielded by loads 106a-h and are also negligibly impacted.

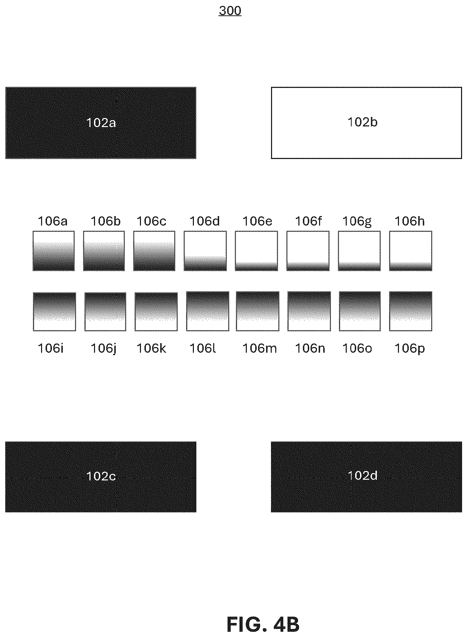

FIGS. 4B-4D are simplified schematics of the environment 300 in FIG. 3 depicting a load-specific impact of climate control units 102c-d, respectively in response to a temperature setting decrease (e.g., increased cooling), in accordance with one or more embodiments of the present disclosure. Due to the symmetry of the environment 300 as well as the symmetric layout of the climate control units 102 and the loads 106, FIGS. 4B-4D depict similar load-specific trends as shown in FIG. 4A, where loads 106 adjacent to the first climate control unit 102a are more substantively impacted than loads 106 that are further away and/or shielded.

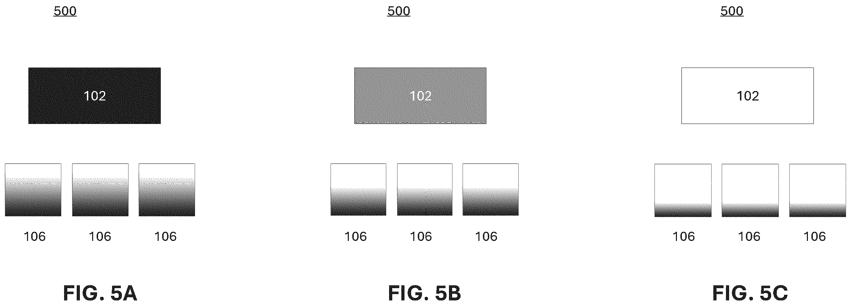

As described previously herein, the load-specific impact data may include data associated with different increments of an operational setting (e.g., temperature, humidity, fan-speed, or the like). FIG. 5A is a simplified schematic of an environment 500 with one of the climate control units 102 in a first operational setting, in accordance with one or more embodiments of the present disclosure. For example, FIG. 5A may correspond to a steady-state condition. FIG. 5B is a simplified schematic of an environment 500 with one of the climate control units 102 in a second operational setting, in accordance with one or more embodiments of the present disclosure. For example, FIG. 5B may correspond to a condition in which a temperature setting climate control unit 102 is adjusted relative to FIG. 5A by one increment. FIG. 5C is a simplified schematic of an environment 500 with one of the climate control units 102 in a third operational setting, in accordance with one or more embodiments of the present disclosure. For example, FIG. 5C may correspond to a condition in which a temperature setting climate control unit 102 is adjusted relative to FIG. 5A by two increments. As illustrated in FIGS. 5A-5C, different adjustments to an operational setting (e.g., different increments) may have varying degrees of impact on the loads 106.

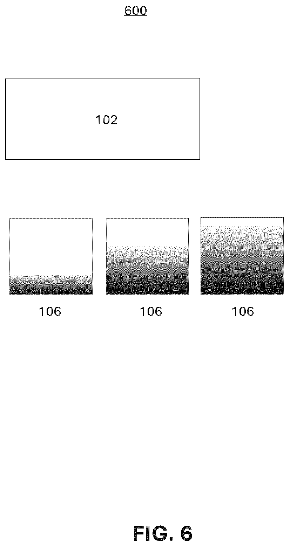

It is noted that FIGS. 5A-5C depict uniform impacts on multiple loads 106 in response to the operational setting of a climate control unit 102. However, this is not always the case. In some cases, a climate control unit 102 may have disparate impacts on different loads 106. FIG. 6 is a simplified schematic depicting a configuration of the environment 600 in which a particular operational setting of the climate control unit 102 provides different temperature profiles on loads 106a-c, in accordance with one or more embodiments of the present disclosure. It is contemplated herein that disparate impacts on different loads 106 may be the result of numerous considerations such as, but not limited to, varying distance between the climate control unit 102 and the loads 106, different heat densities of the loads 106, different operating states of the loads 106, different designs of the loads 106, or the particular distribution of climate control units 102 and loads 106. Further, it is noted that similar disparate impacts were also depicted in FIGS. 4A-4D.

It is contemplated herein that the step 204 of determining load-specific impacts associated with various climate control units 102 may be implemented in a variety of ways. For example, the step 204 may be triggered at selected times or selected intervals. As another example, the step 204 may be based on a condition (e.g., reaching a steady-state condition for a selected amount of time, or any other suitable condition).

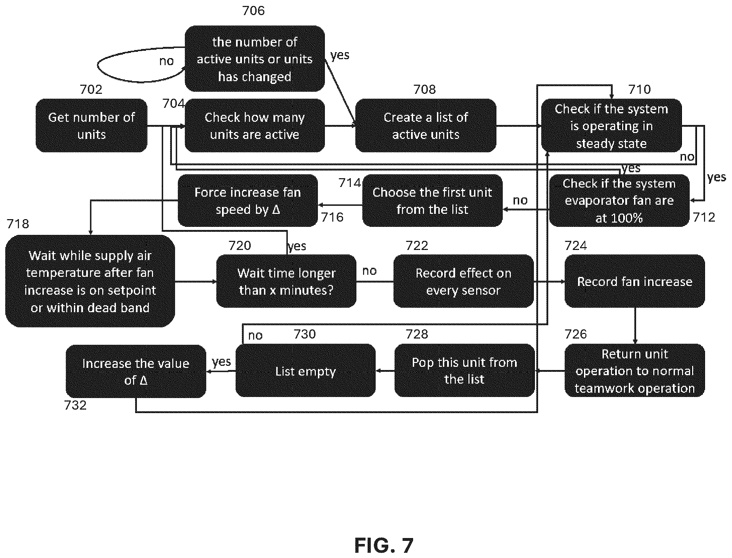

FIG. 7 is a flow diagram depicting the determination of load-specific impacts associated with various climate control units 102, in accordance with one or more embodiments of the present disclosure. In particular, FIG. 7 depicts the adjustment of fan speed of climate control units 102 as an operational setting for climate control. It is noted that the steps in FIG. 7 are merely illustrative of one possible implementation.

For example, a number of climate control units 102 may be determined (box 702) as a starting point. Boxes 704, 706, 708 depict the generation and updating of active climate control units 102 that may participate in location-aware climate control. The specific steps depicted (e.g., creating and updating a list of active units) are merely illustrative.

If the climate control system 100 is operating in a steady state (box 710) and the climate control units 102 are not operating at 100% fan speed (box 712), a first climate control unit 102 may be selected for controlled activation (box 714), then the fan speed of that climate control unit 102 may be increased by a selected increment (Δ) (box 716). For example, if the climate control unit 102 is operating on lower than 100%, then increase evaporator fan speed by force by n-th of the value between 100% and the actual fan speed. As an illustration, if the climate control unit 102 is running at 80% and n is equal to four, then the increments (Δ) are (100-80)/4 = 5%. After a selected wait time, the effect on each loads 106 may be recorded by the various climate sensors 104 and associated with the fan speed as load-specific impact data (e.g., boxes 718,720,722,724). Then, the climate control unit 102 may be returned to normal operational condition (box 726). This process may then be repeated for different climate control units 102 and/or different increments (e.g., boxes 728,730,732).

As described previously herein, the load-specific impact data may be associated with any combination of operational settings (e.g., temperature settings, humidity settings, fan speed settings, or the like) of any number of climate control units 102. For example, the flow diagram in FIG. 7 may be repeated for temperature setpoints as the operational setting. As an illustration, if the climate control unit 102 is operating at a temperature setpoint (e.g., a supply air setpoint) of 24 °C, has an operational range of 3 °C (e.g., an operational range of 21-24 °C), and six increments (Δ) are desired, the range of temperature setpoints characterized in step 204 may be [24 - 3 : 3/6 : 24] or [21.0, 21.5, 22.0, 22.5, 23.0, 23,5 24.0]. Again, it is noted that this particular example is merely an illustration and should not be interpreted as limiting on the scope of the present disclosure.

When multiple operational setting are considered (e.g., both temperature settings and fan speed settings, the climate control system 100 may either select the most effective settings when responding to a climate anomaly (e.g., step 208) or may adhere to user-selected preferences.

For example, in some cases, it is more cost effective to lower the deliverable air temperature and distract the airflow. Usually, it is a case when the fans are already running at high speed and any small incremental increase would have a quadratic effect of the energy consumption on the fans. Accordingly, a user may select desired operational settings to be used for control and/or the number of setpoints.

It is contemplated herein that the amount of load-specific impact data may depend on multiple factors such as, but not limited to, the number of operational settings, the number of increments considered, the number of climate control units 102, and/or the number of climate sensors 104 providing information associated with any particular load 106.

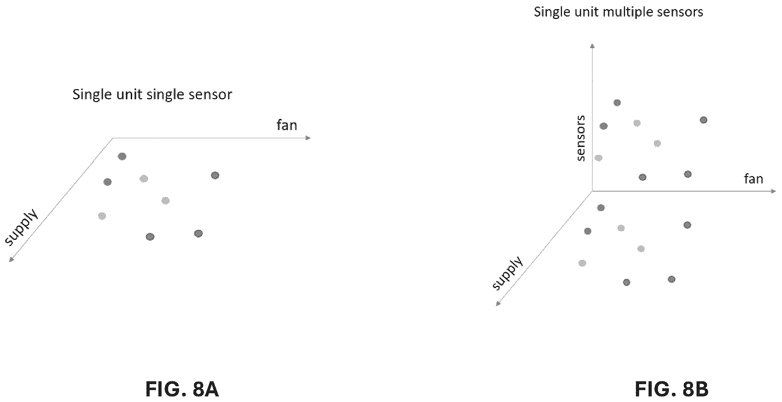

FIGS. 8A-8C depict load-specific impact data in multiple configurations based on the example above of two operational settings: temperature setpoint (labeled as supply) and fan speed (labeled as fan). In particular, the plots in FIGS. 8A-8C depict increased the temperature of a load 106 as characterized by one or more climate sensors 104 using a gradient, where white represents a relatively colder temperature and black represents a relatively warmer temperature. Further, positive values on any of the axes are used to represent increased activation of a climate control unit 102 to induce cooling (e.g., increasing fan speed or reducing a temperature setpoint).

FIG. 8A depicts a distribution of load-specific impact data for a single climate control unit 102 and a single climate sensor 104 per load 106, in accordance with one or more embodiments of the present disclosure. In this example, the load-specific impact data has a two-dimensional distribution, where the temperature of the load 106 may be decreased by either adjusting the temperature setpoint or the fan speed.

FIG. 8B depicts a distribution of load-specific impact data for a single climate control unit 102 and multiple climate sensors 104, in accordance with one or more embodiments of the present disclosure. In this configuration, multiple climate sensors 104 in the environment may provide data indicative of a temperature around a single load 106, which may provide additional load-specific impact data associated with the impact of a change of an operational setting of a climate control unit 102 on a load 106.

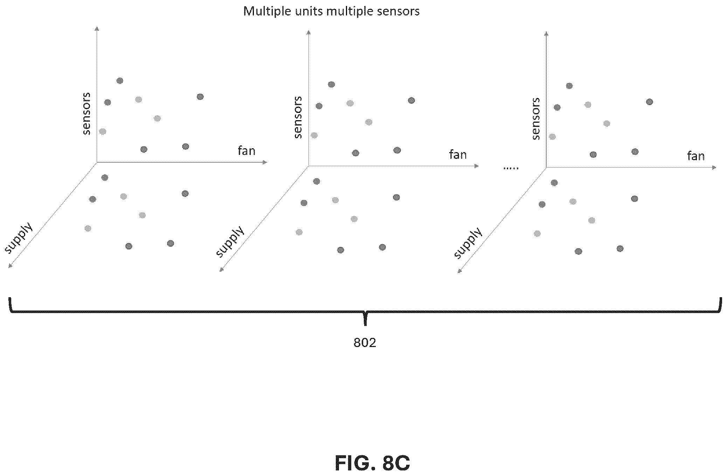

FIG. 8C depicts a distribution 802 of load-specific impact data for multiple climate control units 102 and multiple climate sensors 104, in accordance with one or more embodiments of the present disclosure. In this configuration, various climate sensors 104 distributed around an environment may provide data associated with any number of loads 106.

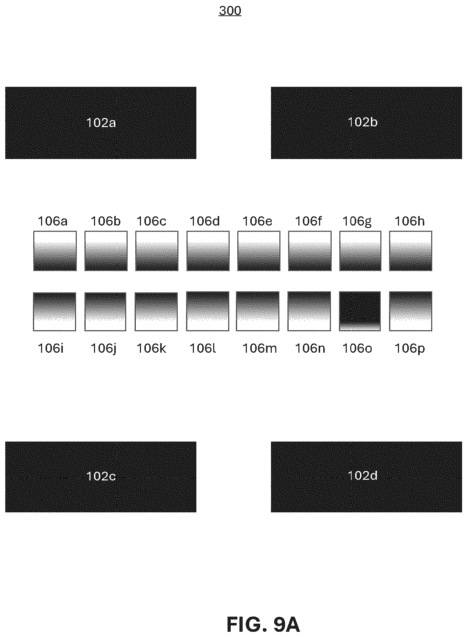

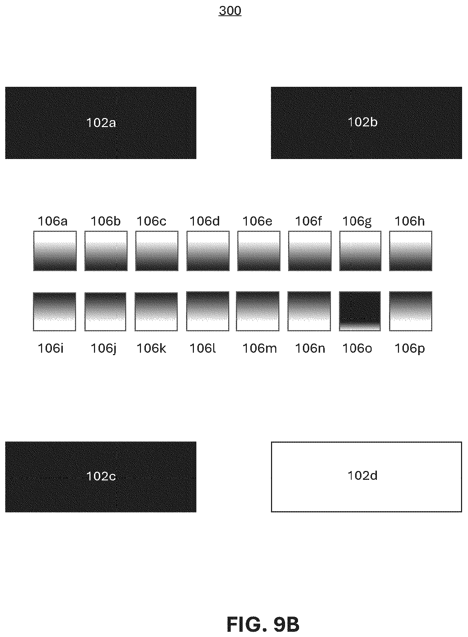

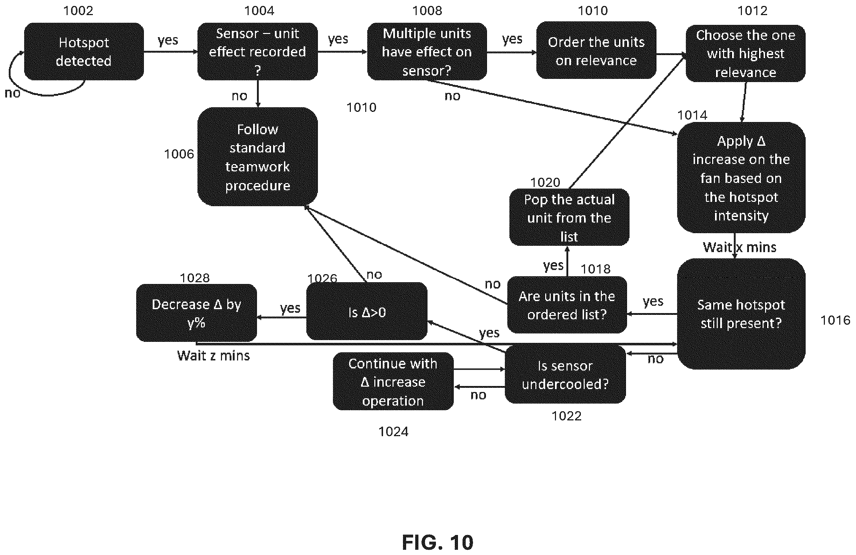

Referring now to FIGS. 9A, 9B, and 10, a targeted climate adjustment based on an identified hotspot is described in greater detail, in accordance with one or more embodiments of the present disclosure.

FIG. 9A is a schematic of the environment 300 in FIG. 3 in which a load 106o exhibits an increased temperature (e.g., a localized climate anomaly or hotspot), in accordance with one or more embodiments of the present disclosure. Based on the load-specific impact data generated in step 204, it may be determined that the climate control unit 102d has the greatest impact on the load 106o and may thus be activated (e.g., in step 208) to mitigate the hotspot. FIG. 9B is a schematic of the environment 300 in FIG. 9A in which the climate control unit 102d is activated to mitigate the hotspot and reduce the temperature of the load 106o, in accordance with one or more embodiments of the present disclosure. Such an approach may be substantially more efficient at mitigating the hotspot and controlling the climate within the environment 300 as a whole than a traditional approach in which all climate sensors 104a-d are activated. In particular, activation of all climate sensors 104a-d may undercool the loads 106 not associated with the hotspot, which is energy and cost inefficient.

In some embodiments, the step 208 may monitor the effectiveness of a targeted climate adjustment and adjust the operational settings of the activated climate control unit 102 (e.g., increase the intensity of a response by lowering a temperature setting, increasing a fan speed, or the like) and/or activate additional climate control units 102 as necessary based on the load-specific impact data. For example, at any given time, the load-specific impact data may be used to determine the next best action that would most efficiently mitigate the hotspot.

It is contemplated herein that a targeted climate adjustment may be implemented in numerous ways within the scope of the present disclosure.

FIG. 10 is a flow diagram depicting the implementation of a targeted climate adjustment (e.g., associated with step 208) by selected climate control units 102 in response to an identified hotspot (e.g., a localized climate anomaly identified in step 206), in accordance with one or more embodiments of the present disclosure. In particular, FIG. 10 depicts the adjustment of fan speed of climate control units 102 as an operational setting for climate control based on load-specific impact data generated based on the flow diagram in FIG. 7. It is noted that the steps in FIG. 10 are merely illustrative of one possible implementation.

Box 1002 represents hotspot identification (e.g., associated with step 206). If no load-specific impact data has been generated that describes an impact of operational setting adjustments to one or more climate control units 102 on a load 106 associated with the hotspot (box 1004), then a traditional teamwork procedure may be used to mitigate the hotspot (box 1006). However, if load-specific data relevant to this hotspot has been generated, a targeted climate adjustment may be used. The number of climate control units 102 identified as having an input on the hotspot identified by the sensor (box 1008). If multiple climate control units 102 are identified as having an impact on the hotspot, then the relative impact of the climate control units 102 may be ranked (box 1010) and the climate control unit 102 having the greatest impact (e.g., a highest-ranked climate control unit 102) may be chosen (box 1012) and activated (box 1014). For example, box 1014 depicts applying an increased fan speed based on the hotspot intensity. If a single climate control unit 102 is identified as having an impact on the hotspot, then that climate control unit 102 may be activated.

After a selected interval (e.g., x minutes), if the hotspot is still present (box 1016), additional climate control units 102 may be activated as necessary to mitigate the hotspot (boxes 1018,1020). If targeted climate adjustments are insufficient to mitigate the hotspot, then a traditional teamwork procedure may be used to mitigate the hotspot (box 1006).

Once the hotspot is mitigated, the climate control system 100 may check to see if the load 106 associated with the hotspot is undercooled (e.g., if there was an overcorrection) (box 1022). If not, the new operational setpoint may be maintained (box 1024). If the load 106 associated with the hotspot is undercooled and any climate control units 102 used for the targeted climate adjustment are still activated (e.g., operating at increased levels (Δ > 0) relative to steady-state operation) (e.g., box 1026), then the operational setpoints of any of those climate control units 102 may be adjusted back to a steady-state value or to an intermediate level (e.g., box 1028) until the load 106 maintains a steady-state condition and is not undercooled. For example, FIG. 10 indicates that after a selected interval (e.g., z minutes), the climate control system 100 may again check to see if the load 106 associated with the hotspot is still undercooled and repeat the above steps as necessary.

Also disclosed are the following numbered clauses:
1. A climate control system, comprising: a controller configured to be communicatively coupled with a plurality of climate sensors distributed within an environment containing a plurality of loads, and further configured to be communicatively coupled with a plurality of climate control units, wherein the controller includes one or more processors configured to execute program instructions stored on a memory device, wherein the program instructions are configured to cause the one or more processors to: receive localized climate data from the plurality of climate sensors; determine, for each of the plurality of climate control units, load-specific impact data associated with at least one incremental change of one or more operational settings on the plurality of loads based on the localized climate data; identify a localized climate anomaly based on the localized climate data; and provide, in response to the localized climate anomaly, a targeted climate adjustment of at least one of the one or more operational settings of a subset of the plurality of climate control units based on the load-specific impact data.
2. The climate control system of clause 1, wherein the one or more operational settings comprise: at least one of a temperature setting, a humidity setting, or a fan speed.
3. The climate control system of clause 1 or 2, wherein determining, for each of the plurality of climate control units, the load-specific impact data associated with at least one incremental change of one or more operational settings on the plurality of loads based on the localized climate data comprises: implementing, for each of the plurality of climate control units individually, the at least one incremental change of one or more operational settings on the plurality of loads based on the localized climate data; and determining the load-specific impact data associated with the at least one incremental change of one or more operational settings on the plurality of loads.
4. The climate control system of any preceding clause, wherein providing the targeted climate adjustment of the at least one of the one or more operational settings of the subset of the plurality of climate control units based on the load-specific impact data comprises: ranking the plurality of climate control units by relative impact on the localized climate anomaly based on the load-specific impact data; and adjusting the at least one of the one or more operational settings for a highest-ranked one of the plurality of climate control units.
5. The climate control system of any preceding clause, wherein providing the targeted climate adjustment of the at least one of the one or more operational settings of the subset of the plurality of climate control units based on the load-specific impact data comprises: ranking the plurality of climate control units by relative impact on the localized climate anomaly based on the load-specific impact data; and adjusting the at least one of the one or more operational settings for one or more additional climate control units of one of the plurality of climate control units based on the rank.
6. The climate control system of any preceding clause, wherein the load-specific impact data includes positional information associated with the plurality of loads within the environment.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

1. A climate control system (100), comprising:
a plurality of climate sensors (104) distributed within an environment containing a plurality of loads;
a plurality of climate control units (102) distributed within the environment; and
a controller (108) communicatively coupled with the plurality of climate sensors and the plurality of climate control units, wherein the controller includes one or more processors (110) configured to execute program instructions stored on a memory device (112), wherein the program instructions are configured to cause the one or more processors to:
receive localized climate data from the plurality of climate sensors;
determine, for each of the plurality of climate control units, load-specific impact data associated with at least one incremental change of one or more operational settings on the plurality of loads based on the localized climate data;
identify a localized climate anomaly based on the localized climate data; and
provide, in response to the localized climate anomaly, a targeted climate adjustment of at least one of the one or more operational settings of a subset of the plurality of climate control units based on the load-specific impact data.

2. The climate control system of claim 1, wherein the one or more operational settings comprise:
at least one of a temperature setting, a humidity setting, or a fan speed.

3. The climate control system of claim 1 or 2, wherein determining, for each of the plurality of climate control units, the load-specific impact data associated with at least one incremental change of one or more operational settings on the plurality of loads based on the localized climate data comprises:
implementing, for each of the plurality of climate control units individually, the at least one incremental change of one or more operational settings on the plurality of loads based on the localized climate data; and
determining the load-specific impact data associated with the at least one incremental change of one or more operational settings on the plurality of loads.

4. The climate control system of any preceding claim, wherein the localized climate anomaly comprises a hotspot.

5. The climate control system of any preceding claim, wherein providing the targeted climate adjustment of the at least one of the one or more operational settings of the subset of the plurality of climate control units based on the load-specific impact data comprises:
ranking the plurality of climate control units by relative impact on the localized climate anomaly based on the load-specific impact data; and
adjusting the at least one of the one or more operational settings for a highest-ranked one of the plurality of climate control units.

6. The climate control system of any preceding claim, wherein providing the targeted climate adjustment of the at least one of the one or more operational settings of the subset of the plurality of climate control units based on the load-specific impact data comprises:
ranking the plurality of climate control units by relative impact on the localized climate anomaly based on the load-specific impact data; and
adjusting the at least one of the one or more operational settings for one or more additional climate control units of one of the plurality of climate control units based on the rank.

7. The climate control system of any preceding claim, wherein the load-specific impact data includes positional information associated with the plurality of loads within the environment.

8. A climate control method (200), comprising:
receiving localized climate data from a plurality of climate sensors (104) distributed within an environment containing a plurality of loads (106);
determining (204), for each of a plurality of climate control units (102) within the environment, load-specific impact data associated with at least one incremental change of one or more operational settings on the plurality of loads based on the localized climate data;
identifying (206) a localized climate anomaly based on the localized climate data; and
providing (208), in response to the localized climate anomaly, a targeted climate adjustment of at least one of the one or more operational settings of a subset of the plurality of climate control units based on the load-specific impact data.

9. The climate control method of claim 8, wherein the one or more operational settings comprise:
at least one of a temperature setting, a humidity setting, or a fan speed.

10. The climate control method of claim 8 or 9, wherein determining, for each of the plurality of climate control units, the load-specific impact data associated with at least one incremental change of one or more operational settings on the plurality of loads based on the localized climate data comprises:
implementing for each of the plurality of climate control units individually, the at least one incremental change of one or more operational settings on the plurality of loads based on the localized climate data; and
determining the load-specific impact data associated with the at least one incremental change of one or more operational settings on the plurality of loads.

11. The climate control method of any of claims 8 to 10, wherein the localized climate anomaly comprises a hotspot.

12. The climate control method of any of claims 8 to 11, wherein providing the targeted climate adjustment of the at least one of the one or more operational settings of the subset of the plurality of climate control units based on the load-specific impact data comprises:
ranking the plurality of climate control units by relative impact on the localized climate anomaly based on the load-specific impact data; and
adjusting the at least one of the one or more operational settings for a highest-ranked one of the plurality of climate control units.

13. The climate control method of any of claims 8 to 12, wherein providing the targeted climate adjustment of the at least one of the one or more operational settings of the subset of the plurality of climate control units based on the load-specific impact data further comprises:
ranking the plurality of climate control units by relative impact on the localized climate anomaly based on the load-specific impact data; and
adjusting the at least one of the one or more operational settings for one or more additional climate control units of one of the plurality of climate control units based on the rank.

14. The climate control method of any of claims 8 to 13, wherein the load-specific impact data includes positional information associated with the plurality of loads within the environment.
